# EUROPÄISCHE PATENTSCHRIFT

(11) **EP 2 561 732 B1**
(45) Veröffentlichungstag und Bekanntmachung des Hinweises auf die Patenterteilung: **17.05.2017**
(21) Anmeldenummer: 11703817.4
(22) Anmeldetag: 20.01.2011
(51) Int. Cl.: H05K 5/02, H05K 5/06

(54) **EIN GEHÄUSE MIT EINEM VERFORMUNGSBEREICH ZUM DRUCKAUSGLEICH SOWIE EINE ANORDNUNG EINES DICHTUNGSELEMENTS IN DEM GEHÄUSE**
HOUSING HAVING A DEFORMATION AREA FOR PRESSURE EQUALIZATION AND ARRANGEMENT OF A SEALING ELEMENT IN THE HOUSING
BOÎTIER AVEC UNE ZONE DE DÉFORMATION POUR COMPENSATION DE PRESSION ET AGENCEMENT D'UN ÉLÉMENT D'ÉTANCHÉITÉ DANS LE BOÎTIER

(30) Priorität: 21.04.2010 DE 102010015674
(43) Veröffentlichungstag der Anmeldung: 27.02.2013
(73) Patentinhaber: WABCO GmbH, 30453 Hannover (DE)
(72) Erfinder: FUHRMANN, Ingo, 30855 Langenhagen (DE); GENSINK, Jan, 30826 Garbsen (DE); STEINFELD, Dieter, 30455 Hannover (DE)
(74) Vertreter: Lauerwald, Jörg
(86) Internationale Anmeldenummer: PCT/EP2011/000229
(87) Internationale Veröffentlichungsnummer: WO 2011/131265

(56) Entgegenhaltungen:
- EP-A1- 0 838 869
- EP-A2- 0 864 805
- CH-A- 497 107
- DE-A1-102007 063 191

## Beschreibung

Die Erfindung betrifft ein Gehäuse, insbesondere aus Kunststoff, zur Aufnahme zumindest einer technischen Funktionseinheit, insbesondere eines elektronischen Bauelements, wobei das Gehäuse zumindest zwei Gehäuseteile aufweist, welche in einer Kontaktebene entlang einer Dichtfläche gasdicht miteinander verbunden sind, wobei zum Ausgleich von Druckschwankungen zumindest ein Gehäuseteil einen elastisch verformbaren Verformungsbereich aufweist.

Derartige Gehäuse, beispielsweise für elektronische oder mechatronische Funktionseinheiten, werden in großen Stückzahlen hergestellt. Insbesondere beim Einsatz unter schwierigen Umgebungsbedingungen, wie beispielsweise in Kraftfahrzeugen, ermöglichen solche Gehäuse einen ausreichenden Schutz der im Gehäuse angeordneten Funktionseinheiten. Insbesondere muss das unkontrollierte Eindringen von Wasser in das Gehäuse verhindert werden. Hierzu sind solche Gehäuse mit einer umlaufenden elastischen Dichtung versehen, welche ein Oberteil gegen ein Unterteil des Gehäuses im zusammengebauten Zustand abdichtet. Aus der DE 197 04 532 A1 sowie der EP 0 772 959 B1 sind solche wasserdichten Elektronikgehäuse bekannt, welche aus einem Oberteil und einem Unterteil bestehen, wobei die beiden Teile im zusammengebauten Zustand durch eine umlaufende Dichtung gegeneinander abgedichtet sind.

Daneben ist es aber auch bereits bekannt, dass das Gehäuse einen kontrollierten Druckausgleich zur umgebenden Atmosphäre gestattet. Hierdurch wird die Bildung von Kondenswasser im Inneren des Gehäuses bei wechselnden Umgebungstemperaturen verhindert. Weiter wird hierdurch bei Funktionseinheiten, welche auch mit einer Einspeisung von Druckluft in das Gehäuse arbeiten können, ein eventueller, schädlicher Überdruck im Gehäuse verhindert.

Aus der DE 100 22 124 A1 ist außerdem ein Gehäuse für ein elektronisches Steuergerät bekannt, welches zur Ent- bzw. Belüftung eine Druckentlüftungsbohrung aufweist. Diese verhindert die Bildung von Kondenswasser im Gehäuse und hält weiterhin den Druck im Innenraum auf Atmosphärendruck.

Gehäuse mit einer Druckentlastungsbohrung haben jedoch den Nachteil, dass durch die Bohrung eventuell Schmutzwasser in den Innenraum eindringen kann. Hierdurch können empfindliche Bauelemente beschädigt werden.

Zur Lösung dieses Problems wird in der DE 10 2004 028 199 A1 eine Vorrichtung zur Druckentlastung vorgeschlagen, die in die umlaufende Dichtung zwischen Oberteil und Unterteil integriert ist, um so zum einen durch eine Labyrinthwirkung eine weitgehende Abdichtung des Gehäuses gegen äußeres Schmutzwasser zu erzielen und zum anderen durch ein Lippenprofil auch ein schnelles Ablassen eines Überdrucks vom Innenraum ins Freie zu ermöglichen. Als nachteilig erweist sich dabei das komplizierte Lippenprofil und die damit verbundenen erhöhten Herstellungskosten.

In der EP 0 961 534 A1 wird außerdem ein Verformungsbereich an zumindest einem Gehäuseteil vorgeschlagen, welcher aufgrund seiner elastischen Verformung eine Veränderung des Gehäuseinnenvolumens ermöglicht. Auf diese Weise findet der Druckausgleich aufgrund der Volumenanpassung statt, wobei ein Überströmen von Luft aus oder in den Gehäuseinnenraum ausgeschlossen ist.

Aus der DE 38 17 227 A1 ist ein elektrisches Gerät mit einem Druckausgleichselement bekannt, bei dem das Druckausgleichselement in eine Gehäuseöffnung eingesetzt ist. Nachteilig ist bei dieser Ausführung, dass einerseits das Druckausgleichselement aus vielen Einzelteilen aufgebaut ist und andererseits ein zusätzlicher Fügevorgang zur Befestigung des Druckausgleichelements im Gehäuse erforderlich ist. Weiterhin schlägt die WO 2006/056504 A1 ein Druckausgleichselement vor, welches das Eindringen von Feuchtigkeit vermeidet, wobei das Druckausgleichselement eine gasdurchlässige Membran und einen der Membran vorgelagerten Prallschutz aufweist, der ein direktes Bespritzen der Membran durch eine Flüssigkeit vermeidet.

Als nachteilig erweist sich bei den bisherigen Lösungen der für einen Druckausgleich zwischen dem Gehäuseinnenraum und der Umgebung erforderliche konstruktive Mehraufwand. Insbesondere sind hierzu zusätzliche Bauelemente, beispielsweise eine Membran, oder aber eine spezielle Formgebung der Dichtung mit der Folge einer erforderlichen Anpassung der Gehäuseteile nötig. Das Dokument EP 0 838 869 A1 offenbart ein feuchtigkeitsdichtes Gehäuse, bei dem zum Zwecke des Gasaustausches (bzw. zum Zwecke des Gas-Überdruckabbaus) ein Verformungsbereich vorgesehen ist, welcher zum Zwecke des Gasaustausches eine Öffnung frei gibt.

Der Erfindung liegt die Aufgabe zugrunde, eine ohne wesentliche konstruktive Änderungen und ohne zusätzliche Bauelemente realisierbare Möglichkeit zum Ausgleich von Druckschwankungen im Verhältnis des Gehäuseinnenraums gegenüber der Umgebung zu schaffen.

Die Aufgabe wird erfindungsgemäß mit einem Gehäuse gemäß den Merkmalen des Anspruchs 1 gelöst. Die weitere Ausgestaltung der Erfindung ist den Unteransprüchen zu entnehmen. Erfindungsgemäß ist also der Verformungsbereich eine Öffnung zum Gasaustausch zwischen einem Gehäuseinnenraum und der Umgebung freigebend verformbar ausgeführt. Hierdurch wird in überraschend einfacher Weise durch die elastische Verformung eine Öffnung des Gehäuseinnenraums zu der Umgebung geschaffen, die einen freien Gasaustausch ermöglicht. Nach dem erfolgten Druckausgleich nimmt der Verformungsbereich aufgrund der elastischen Materialeigenschaften zuverlässig seine dichtende Grundposition ein, sodass auf zusätzliche Druckausgleichsventile verzichtet werden kann. Dabei ist der Druckausgleich nicht auf einen Überdruck im Gehäuseinneren beschränkt, sondern umfasst ebenso einen Unterdruck im Gehäuseinneren gegenüber der Umgebung. Selbstverständlich kann auf diese Weise auch der Druckausgleich zwischen verschiedenen Gehäusen sichergestellt werden. Erfindungsgemäß hat das Gehäuse eine in der Kontaktebene angeordnete, einen Gasaustausch zwischen Gehäuseinnenraum und Umgebung ermöglichende Auflagefläche, wobei zumindest ein Gehäuseteil in dieser Kontaktebene entgegen der Rückstellkraft einer elastischen Verformung von der Dichtfläche zur Auflagefläche verlagerbar ist. Hierdurch wird also aufgrund der elastischen Verformung des Gehäuseteils, die durch den Verformungsbereich realisiert ist, aufgrund einer Druckdifferenz die Dichtungswirkung der entlang in der Grundposition in der Kontaktebene dichtend gegen die Dichtfläche liegenden Gehäuseteile vorübergehend unterbrochen. Dabei wird eine definierte Verlagerung in der Kontaktebene sichergestellt, indem sich die Auflagefläche der Dichtfläche flächenbündig anschließt, sodass kein unbestimmter Spalt zwischen den Gehäuseteilen entsteht. Vielmehr wird bereits nach einer minimalen Verlagerung, bevorzugt in lateraler oder radialer Richtung, die sich beispielsweise auf wenige Millimeter beschränken kann, die Auflagefläche erreicht, und so unter Aufrechterhaltung eines mechanischen Kontakts des Gehäuseteils und einer zuverlässigen Führung des auf der Auflage verlagerten bzw. verschobenen Gehäuseteils ein Gasaustausch ermöglicht.

Dadurch, dass gemäß einer bevorzugten Ausführungsform der Verformungsbereich die Dichtfläche einschließt und in Abhängigkeit der möglichen Druckdifferenz durch einen Überdruck oder Unterdruck im Gehäuseinnenraum entgegen der elastischen Rückstellkraft der Verformung eine relative Verlagerung in der Kontaktebene hin zu einer den Gasaustausch zwischen dem Gehäuseinnenraum und der Umgebung ermöglichende Auflagefläche zumindest eines Gehäuseteils eintritt und die Gehäuseteile nach einem Gasaustausch in ihre gasdicht verschlossene Ausgangsposition zurückkehren, wird der Druckausgleich ohne wesentliche konstruktive Änderungen und ohne ein Druckausgleichsventil realisiert, sodass die Herstellungskosten wesentlich gesenkt werden können. Weiterhin entfällt auf diese Weise der zum Einbau eines Druckausgleichsventils erforderliche Platzbedarf.

Dabei ist es besonders vorteilhaft, wenn gemäß einer Ausführungsform der Erfindung die Auflagefläche eine zumindest abschnittsweise gasdurchlässige Beschaffenheit aufweist. Indem die Auflagefläche beispielsweise eine poröse oder gitterartige Struktur aufweist, bleibt auch in der verformten Position des Gehäuseteils dessen ununterbrochener Kontakt und damit die gewünschte mechanische Stabilität des Gehäuses erhalten. Erfindungsgemäß wird der gewünschte Gasaustausch dadurch erreicht, dass die Auflagefläche Strukturierungen oder partielle, durch Nuten in der Auflagefläche gebildete Ausnehmungen aufweist. Hierdurch wird ein schneller und ungehinderter Gasdurchtritt ermöglicht, sodass der Verformungsbereich auf vergleichsweise kleine Flächen von beispielsweise wenigen Quadratzentimeter beschränkt werden kann. Zudem kann in Ausnehmungen auch eine Ausformung vorgesehen sein, durch die eintretende Partikel zurückgehalten werden. Ferner kann die Orientierung derart vorgesehen sein, dass die in das Gehäuse einströmende Luft zunächst nach oben abgelenkt wird, sodass Staubpartikel schwerkraftbedingt zurückgehalten werden. Erfindungsgemäß weisen die Ausnehmungen in Richtung der Verlagerung des Gehäuseteils eine zunehmende freie Querschnittsfläche auf, sodass der durch diese freie Querschnittsfläche bestimmte Lufteinlass entsprechend der zunehmenden Verformung stetig zunimmt.

Weiterhin erweist es sich als besonders zweckmäßig, wenn jedes Gehäuseteil eine Auflagefläche mit Strukturierungen oder partiellen Ausnehmungen aufweist, die einander gegenüberliegend angeordnet sind. Hierdurch wird der Gasdurchtritt weiter begünstigt, indem beide Gehäuseteile korrespondierende, als Gegennuten ausgeführte Durchlassöffnungen freigeben.

Die Auflagefläche könnte als ein zusätzliches Element des Gehäuses ausgeführt sein. Besonders vorteilhaft ist es hingegen, wenn die Auflagefläche als ein integraler Bestandteil eines Gehäuseteils ausgeführt ist, sodass der beispielsweise als eine Abwinkelung ausgeführte flanschartige, die Kontaktebene bildende Randbereich sowohl die Dichtfläche als auch die Auflagefläche aufweist, die hierzu einteilig miteinander verbunden sein können.

Die Richtung der relativen Verlagerung ist abhängig von der jeweiligen Geometrie des Gehäuses. Besonders vorteilhaft ist jedoch insbesondere auch eine Abwandlung, bei welcher zumindest ein Gehäuseteil durch die elastische Verformung quer zur Haupterstreckung eines die Gehäuseteile verbindenden Dichtungselements beweglich ausgeführt ist, sodass die Verlagerung quer zur Haupterstreckung des Dichtungselements erfolgt, wobei der bei der Verlagerung maximal zurückgelegte Weg zumindest der Breite des Dichtungselements entspricht.

Hierzu eignet sich besonders eine Ausgestaltung der Erfindung, bei welcher das Dichtungselement eine Ringdichtung mit einer insbesondere kreisförmigen Querschnittsform aufweist. Diese ermöglicht eine schnelle und problemlose Verlagerung quer zu ihrer Haupterstreckung, wobei beispielsweise neben einer Verschiebung auf der Dichtfläche auch eine Rollbewegung um die Längsachse des Dichtungselements die seitliche Verlagerung begünstigen kann, um so den Reibungswiderstand zu verringern.

Hierzu eignet sich bevorzugt eine Weiterbildung der Erfindung, bei welcher das Dichtungselement mit einem Gehäuseteil insbesondere formschlüssig verbunden und entlang der Dichtfläche relativ zu dem anderen Gehäuseteil auf der Dichtfläche bis zu der Auflagefläche verschiebbar ist. Dabei wird also das Dichtungselement mittels des elastisch verformten Gehäuseteils insbesondere nach außen verlagert und gelangt so auf die Auflagefläche, deren Ausnehmungen ein Unter- oder Überströmen des Dichtungselements ermöglicht. Es wird so durch die seitliche Verlagerung die Dichtungswirkung vorübergehend reduziert oder aufgehoben.

Die erfindungsgemäß ausgestaltete Auflagefläche könnte umlaufend an dem Gehäuse angebracht werden, sodass eine Verformung in einem beliebigen Bereich der Dichtfläche zu dem gewünschten Gasaustausch führt. Besonders Erfolg versprechend ist es hingegen, wenn der Verformungsbereich durch eine Materialschwächung gebildet oder begrenzt ist. Hierdurch wird die Schwächung des Gehäuses auf einen bestimmten Verformungsbereich beschränkt, sodass eine unerwünschte Instabilität des Gehäuses auch in der verformten Position ausgeschlossen ist.

Das Gehäuse kann grundsätzlich beliebiges technisches oder medizinisches Gerät aufnehmen, wobei das Gehäuse vorzugsweise eine elektronische Steuerung einschließt.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt jeweils in einer perspektivischen Darstellung in
- Fig. 1: einen Ausschnitt eines Gehäuseteils mit einer Dichtfläche;
- Fig. 2: eine vergrößerte Darstellung der in Figur 1 gezeigten Dichtfläche;
- Fig. 3: das in Figur 1 gezeigte, mittels eines Dichtungselements mit einem zweiten Gehäuseteil verbundene Gehäuseteil;
- Fig. 4: eine seitlich verlagerte, den Gasdurchtritt ermöglichende Position des in Figur 3 gezeigten Dichtungselements.

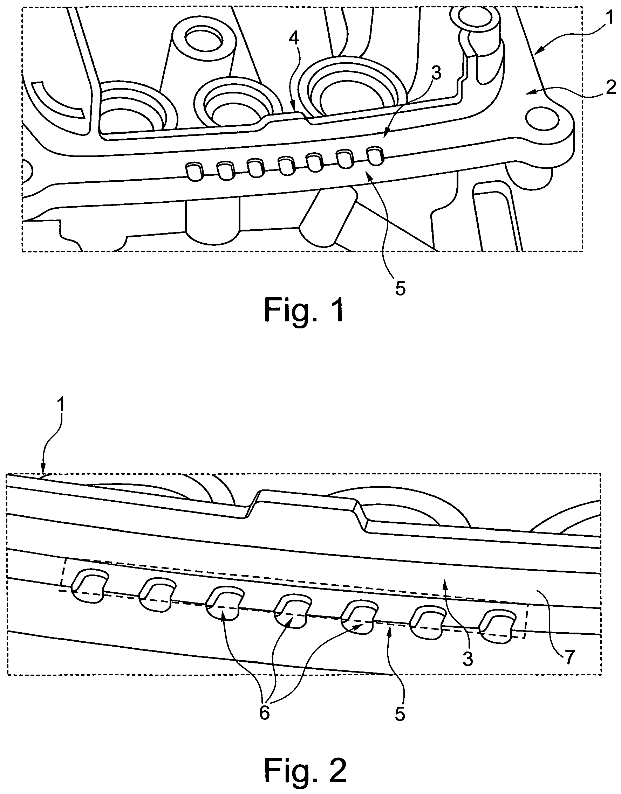

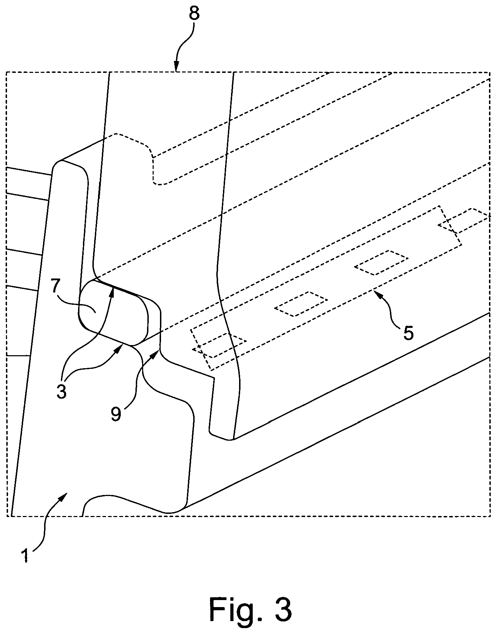

Figur 1 zeigt ein als Gehäuseunterteil ausgeführtes erstes Gehäuseteil 1 eines nicht weiter dargestellten, aus einem Kunststoff hergestellten erfindungsgemäßen Gehäuses. Das Gehäuse dient der Aufnahme einer elektronischen Steuereinheit, sodass besondere Anforderungen an den Schutz vor Umwelteinflüssen erfüllt werden müssen. Hierzu ist das erste Gehäuseteil 1 in einer nicht gezeigten Einsatzposition mit einem als Deckel ausgeführten, in Figur 3 erkennbaren zweiten Gehäuseteil 8 entlang einer eine Kontaktebene 2 definierenden Dichtfläche 3 gasdicht verbunden. Zum Ausgleich von Druckschwankungen hat das erste Gehäuseteil 1 einen elastischen Verformungsbereich 4, der sich bei einem Überdruck nach außen verformt, wodurch ein der Abdichtung zwischen den Gehäuseteilen 1, 8 dienendes, in Figur 2 gezeigtes Dichtungselement 7 in der Ebene der Dichtfläche 3 nach außen auf eine Auflagefläche 5 verschoben wird.

Die besondere Gestaltung der Auflagefläche 5 wird anhand der Figur 2 näher erläutert, die eine vergrößerte Darstellung des in Figur 1 gezeigten Gehäuseteils 1 einschließlich seiner Dichtfläche 3 zeigt. Die Auflagefläche 5 schließt sich der Dichtfläche 3 flächenbündig an und ist mit dieser einteilig verbunden. Die Besonderheit der Auflagefläche 5 liegt darin, dass diese mehrere, als Nuten ausgeführte, partielle Ausnehmungen 6 aufweist, sodass die Auflage des Dichtungselements 7 entsprechend partiell unterbrochen ist. An diesen Brückenstellen wird somit ein Gasaustausch durch die Ausnehmungen 6 bei einer Unterströmung des Dichtungselements 7 erreicht. Zugleich bildet die Auflagefläche 5 eine ausreichende Führung und Abstützung des Dichtungselements 7, sodass dieses problemlos verlagert und in der Kontaktebene entgegen der Rückstellkraft einer differenzdruckabhängigen elastischen Verformung von der Dichtfläche 3 zu der Auflagefläche 5 verlagert werden kann und nach dem Gasaustausch in seine dichtende Ausgangsposition zurückkehrt.

Zum besseren Verständnis ist in Figur 3 zusätzlich eine geschlossene Position des Gehäuses dargestellt, in welcher das erste Gehäuseteil 1 mit dem zweiten Gehäuseteil 8 mittels des Dichtungselements 7 entlang der Dichtfläche 3 verbunden ist. Dabei ist das Dichtungselement 7 an seinem äußeren Umfang von einem Vorsprung 9 des zweiten Gehäuseteils 8 abgedeckt, welches nach einer dem Druckausgleich dienenden Verlagerung die Rückführung des Dichtungselements 7 von der Auflagefläche 5 zu der Dichtfläche 3 unterstützt.

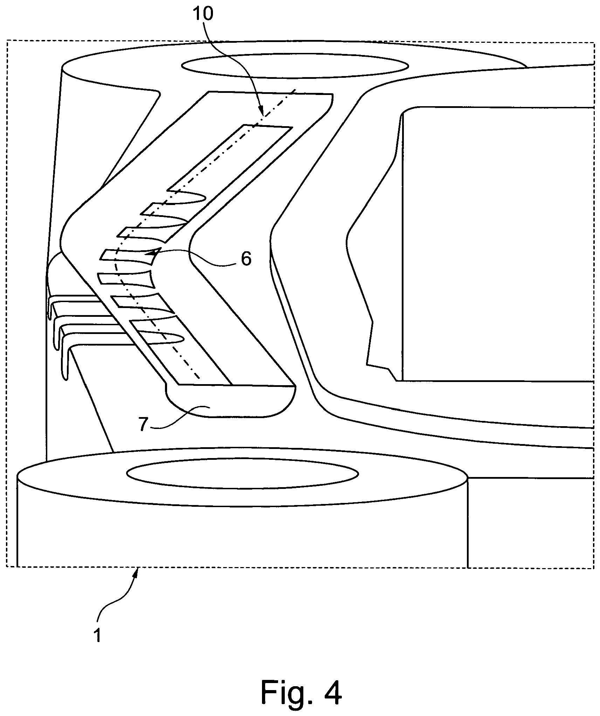

Eine solche, den Gasaustausch ermöglichende, elastisch verformte Position wird in Figur 4 dargestellt. Dabei ist das als O-Ring ausgeführte, jedoch entsprechend der Anordnung zwischen den Gehäuseteilen 1, 8 verformt dargestellte Dichtungselement 7 quer zu seiner Haupterstreckung 10 verlagert. Im Bereich der Ausnehmungen 6 wird ein freier Gasaustausch dadurch ermöglicht, dass das Dichtungselement 7 mit seiner gesamten Breite die Ausnehmungen 6 brückenartig überdeckt, sodass ein Gasdurchlass unterhalb des Dichtungselements 7 in dem kontrastierend dargestellten Bereich erfolgen kann.

## Patentansprüche

1. Ein Gehäuse zur Aufnahme zumindest einer technischen Funktionseinheit, insbesondere eines elektronischen Bauelements, wobei das Gehäuse zumindest ein erstes Gehäuseteil (1) und ein zweites Gehäuseteil (8) aufweist, welche in einer Kontaktebene (2) entlang einer Dichtfläche (3) gasdicht miteinander verbunden sind, wobei zum Ausgleich von Druckschwankungen zumindest das erste Gehäuseteil (1) einen elastisch verformbaren Verformungsbereich (4) aufweist, der aufgrund der elastischen Materialeigenschaften nach erfolgtem Druckausgleich seine dichtende Grundposition einnimmt, wobei der Verformungsbereich (4) eine Öffnung zum Gasaustausch zwischen einem Gehäuseinnenraum und der Umgebung freigebend verformbar ausgeführt ist, wobei das Gehäuse eine in der Kontaktebene (2) angeordnete, einen Gasaustausch zwischen Gehäuseinnenraum und der Umgebung ermöglichende Auflagefläche (5) hat und dass zumindest das erste Gehäuseteil (1) in dieser Kontaktebene (2) entgegen der Rückstellkraft einer elastischen Verformung von der Dichtfläche (3) zur Auflagefläche (5) beweglich ausgeführt ist, **dadurch gekennzeichnet, dass** die Auflagefläche (5) Strukturierungen oder partielle Ausnehmungen (6) aufweist, wobei die Ausnehmungen (6) durch Nuten in der Auflagefläche (5) gebildet sind, welche eine in Richtung der Verlagerung des ersten Gehäuseteils (1) zunehmende freie Querschnittsfläche aufweisen.

2. Gehäuse nach Anspruch 1, **dadurch gekennzeichnet, dass** der Verformungsbereich (4) die Dichtfläche (3) einschließt.

3. Gehäuse nach zumindest einem der vorhergehenden Ansprüche, **dadurch gekennzeichnet, dass** die Auflagefläche (5) eine zumindest abschnittsweise gasdurchlässige Beschaffenheit aufweist.

4. Gehäuse nach Anspruch 1, **dadurch gekennzeichnet, dass** jedes Gehäuseteil (1, 8) eine Auflagefläche (5) mit Strukturierungen und/oder partiellen Ausnehmungen (6) aufweist, die einander gegenüberliegend angeordnet sind.

5. Gehäuse nach zumindest einem der vorhergehenden Ansprüche, **dadurch gekennzeichnet, dass** die Auflagefläche (5) als ein integraler Bestandteil eines der beiden Gehäuseteile (1, 8) ausgeführt ist.

6. Gehäuse nach zumindest einem der vorhergehenden Ansprüche, **dadurch gekennzeichnet, dass** zumindest ein erstes Gehäuseteil (1) durch die elastische Verformung quer zur Haupterstreckung (10) eines die beiden Gehäuseteile (1, 8) verbindenden Dichtungselements (7) beweglich ausgeführt ist.

7. Gehäuse nach Anspruch 6, **dadurch gekennzeichnet, dass** das Dichtungselement (7) eine Ringdichtung mit einer insbesondere kreisförmigen Querschnittsform aufweist.

8. Gehäuse nach Anspruch 6 oder 7, **dadurch gekennzeichnet, dass** das Dichtungselement (7) mit dem ersten Gehäuseteil (1) insbesondere formschlüssig verbunden und entlang der Dichtfläche (3) relativ zu dem zweiten Gehäuseteil (8) auf der Dichtfläche (3) bis zu der Auflagefläche (5) beweglich ist.

9. Gehäuse nach zumindest einem der vorhergehenden Ansprüche, **dadurch gekennzeichnet, dass** der Verformungsbereich (4) durch eine Materialschwächung gebildet ist.

## Claims

1. A housing for accommodating at least one technical functional unit, in particular an electronic component, wherein the housing has at least one first housing part (1) and one second housing part (8) which, in a contact plane (2), are connected to one another in gas-tight fashion along a sealing surface (3), wherein, for compensation of pressure fluctuations, at least the first housing part (1) has an elastically deformable deformation region (4) which, owing to the elastic material characteristics, assumes its sealing basic position after pressure equalization has occurred, wherein the deformation region (4) is designed to be deformable so as to open up an opening for an exchange of gas between a housing interior and the surroundings, wherein the housing has an abutment surface (5) which is arranged in the contact plane (2) and which permits an exchange of gas between housing interior and the surroundings, and in that at least the first housing part (1) is designed to be movable in said contact plane (2) relative to the abutment surface (5) counter to the restoring force of an elastic deformation of the sealing surface (3), **characterized in that** the abutment surface (5) has structurings or partial recesses (6), wherein the recesses (6) are formed by grooves in the abutment surface (5), which grooves have a free cross-sectional area which increases in a direction of the displacement of the first housing part (1).

2. Housing according to Claim 1, **characterized in that** the deformation region (4) includes the sealing surface (3).

3. Housing according to at least one of the preceding claims, **characterized in that** the abutment surface (5) is of a gas-permeable nature at least in sections.

4. Housing according to Claim 1, **characterized in that** each housing part (1, 8) has an abutment surface (5) with structurings and/or partial recesses (6), which are arranged so as to face one another.

5. Housing according to at least one of the preceding claims, **characterized in that** the abutment surface (5) is formed as an integral constituent part of one of the two housing parts (1, 8).

6. Housing according to at least one of the preceding claims, **characterized in that** at least one first housing part (1) is designed to be movable by means of the elastic deformation transversely with respect to the main extent (10) of a seal element (7) which connects the two housing parts (1, 8).

7. Housing according to Claim 6, **characterized in that** the seal element (7) has a ring-shaped seal with an in particular circular cross-sectional shape.

8. Housing according to Claim 6 or 7, **characterized in that** the seal element (7) is connected in particular in positively locking fashion to the first housing part (1) and is movable on the sealing surface (3), along the sealing surface (3) relative to the second housing part (8), as far as the abutment surface (5).

9. Housing according to at least one of the preceding claims, **characterized in that** the deformation region (4) is formed by a material weakening.

## Revendications

1. Boîtier pour recevoir au moins une unité fonctionnelle technique, en particulier un composant électronique, le boîtier présentant au moins une première partie de boîtier (1) et une deuxième partie de boîtier (8) qui sont connectées l'une à l'autre de manière étanche aux gaz dans un plan de contact (2) le long d'une surface d'étanchéité (3), au moins la première partie de boîtier (1), pour compenser les variations de pression, présentant une région de déformation (4) déformable élastiquement qui, en raison des propriétés élastiques du matériau, adopte sa position de base d'étanchéité une fois l'équilibre de pression réalisé, la région de déformation (4) étant réalisée de manière déformable en libérant une ouverture pour l'échange de gaz entre un espace interne du boîtier et l'environnement, le boîtier présentant une surface d'appui (5) disposée dans le plan de contact (2), permettant un échange de gaz entre l'espace interne du boîtier et l'environnement et en ce qu'au moins la première partie de boîtier (1) est réalisée de manière déplaçable dans ce plan de contact (2) à l'encontre de la force de rappel d'une déformation élastique de la surface d'étanchéité (3) par rapport à la surface d'appui (5), **caractérisé en ce que** la surface d'appui (5) présente des structurations ou des évidements partiels (6), les évidements (6) étant formés par des rainures dans la surface d'appui (5), qui présentent une surface en section transversale libre augmentant dans la direction du déplacement de la première partie de boîtier (1).

2. Boîtier selon la revendication 1, **caractérisé en ce que** la région de déformation (4) inclut la surface d'étanchéité (3).

3. Boîtier selon au moins l'une quelconque des revendications précédentes, **caractérisé en ce que** la surface d'appui (5) présente une constitution au moins en partie perméable aux gaz.

4. Boîtier selon la revendication 1, **caractérisé en ce que** chaque partie de boîtier (1, 8) présente une surface d'appui (5) avec des structurations et/des évidements partiels (6) qui sont disposés en regard les uns des autres.

5. Boîtier selon au moins l'une quelconque des revendications précédentes, **caractérisé en ce que** la surface d'appui (5) est réalisée sous forme de constituant intégral de l'une des deux parties de boîtier (1, 8).

6. Boîtier selon au moins l'une quelconque des revendications précédentes, **caractérisé en ce qu'**au moins une première partie de boîtier (1) est réalisée de manière déplaçable par la déformation élastique transversalement à l'étendue principale (10) d'un élément d'étanchéité (7) reliant les deux parties de boîtier (1, 8).

7. Boîtier selon la revendication 6, **caractérisé en ce que** l'élément d'étanchéité (7) présente un joint d'étanchéité annulaire avec une forme notamment circulaire en section transversale.

8. Boîtier selon la revendication 6 ou 7, **caractérisé en ce que** l'élément d'étanchéité (7) est connecté à la première partie de boîtier (1), en particulier par engagement par correspondance de formes, et est déplaçable le long de la surface d'étanchéité (3) par rapport à la deuxième partie de boîtier (8) sur la surface d'étanchéité (3) jusqu'à la surface d'appui (5).

9. Boîtier selon au moins l'une quelconque des revendications précédentes, **caractérisé en ce que** la région de déformation (4) est formée par un affaiblissement de matériau.
